# EUROPEAN PATENT SPECIFICATION

(11) **EP 4 728 930 B1**
(45) Date of publication and mention of the grant of the patent: **26.08.2026**
(21) Application number: 25182353.0
(22) Date of filing: 12.06.2025
(51) Int. Cl.: G06Q 10/087, A47B 88/457, A47B 88/467, A47B 88/463

(54) **INTELLIGENT CABINET SYSTEM**
INTELLIGENTES SCHRANKSYSTEM
SYSTÈME D'ARMOIRE INTELLIGENTE

(30) Priority: 18.10.2024 TW 113139978
(43) Date of publication of application: 22.04.2026
(73) Proprietor: King Slide Technology Co., Ltd., Kaohsiung City 821011 (TW)
(72) Inventor: CHEN, Ken-Ching, 821010 Kaohsiung City (TW); LIU, Chun-Ta, 821010 Kaohsiung City (TW); SU, Hsin-Cheng, 821010 Kaohsiung City (TW); CHANG, Chih-Yuan, 821010 Kaohsiung City (TW); LIN, Shu-Chen, 821010 Kaohsiung City (TW)
(74) Representative: Viering, Jentschura & Partner mbB Patent- und Rechtsanwälte

(56) References cited:
- US-A1- 2017 053 099
- US-A1- 2020 143 315
- US-A1- 2020 226 545

## Description

### Field of the Invention

The present invention is related to an intelligent cabinet system.

### Background of the Invention

In the prior art, an intelligent cabinet comprises a plurality of driving devices, which are usually arranged inside a cabinet body and are configured to open doors or drawers on the cabinet body. The driving devices are configured to communicate with a control device outside the cabinet body in a wireless manner. However, there may be electromagnetic interference between driving devices and the control device, which will affect communication quality of data transmission and may result in delayed transmission due to carrier collision. In addition, each of the driving devices in the cabinet body requires a separate power source (such as a battery) for proper operation. The aforementioned structure has convenience of no wiring required, but it also has problems of signal interference and power source replacement. Moreover, if the power source is continuously in a state of supplying power, it may cause high power consumption problem.

For different market requirements, it is important to develop various products.

US 2017/053099 A1 (COUGHLIN MICHAEL E [US] ET AL) of 23. February 2017 discloses and intelligent cabinet system for use in a pharmacy.

### Summary of the Invention

This in mind, the present invention aims at providing an intelligent cabinet system.

This is achieved by an intelligent cabinet system according to claim 1. The dependent claims pertain to corresponding further developments and improvements.

As will be seen more clearly from the detailed description following below, the claimed an intelligent cabinet system comprises a cabinet body, a plurality of movable members, a control device, a control unit, an electronic module, a power supply module, a sensor and a communication device. The plurality of movable members are arranged on the cabinet body and movable between a retracted position and an open position relative to the cabinet body. The control device is arranged on the cabinet body. The electronic module is electrically connected to the control unit, and the electronic module comprises a driving device configured to drive a driving member to move. The power supply module is configured to supply power to at least one of the control device, the control unit and the electronic module. The sensor is arranged on the cabinet body and configured to sense whether a user is approaching the cabinet body. The communication device is configured to transmit a predetermined signal. When the control device receives the predetermined signal, the control device is configured to notify the control unit to control the driving device to move the driving member to switch from a first predetermined state to a second predetermined state, in order to allow one of the movable members to be moved away from the retracted position. When the sensor senses that a user is approaching the cabinet body, the intelligent cabinet system is configured to be switched from a power saving mode to an operating mode, such that a wireless module of the control device is configured to be activated to receive the predetermined signal from the communication device.

### Brief Description of the Drawings

In the following, the invention is further illustrated by way of example, taking reference to the accompanying drawings thereof:
FIG. 1 is a diagram showing an intelligent cabinet system having a cabinet body arranged with a plurality of movable members according to an embodiment of the present invention;
FIG. 2 is a diagram showing a plurality of slide rail assemblies of the intelligent cabinet system being in a retracted state according to the embodiment of the present invention;
FIG. 3 is a diagram showing the plurality of slide rail assemblies of the intelligent cabinet system being in an open state according to the embodiment of the present invention;
FIG. 4 is a diagram showing the intelligent cabinet system according to the embodiment of the present invention;
FIG. 5 is a diagram showing the intelligent cabinet system having a control device and at least one control unit electrically connected to each other in a wired manner with the control unit being configured to control a corresponding movable member;
FIG. 6 is a diagram showing power supply arrangement of the intelligent cabinet system according to the embodiment of the present invention;
FIG. 7 is a diagram showing a first type of the power supply arrangement of the intelligent cabinet system according to the embodiment of the present invention;
FIG. 8 is a diagram showing a second type of the power supply arrangement of the intelligent cabinet system according to the embodiment of the present invention;
FIG. 9 is a diagram showing a third type of the power supply arrangement of the intelligent cabinet system according to the embodiment of the present invention;
FIG. 10 is a diagram showing one of the movable members on the cabinet body of the intelligent cabinet system being opened according to the embodiment of the present invention;
FIG. 11 is a diagram showing the control device, the control unit and an electronic module electrically connected to each other in a wired manner with a second rail being retracted relative to a first rail of the slide rail assembly according to the embodiment of the present invention;
FIG. 12 is a diagram showing the control device, the control unit and the electronic module electrically connected to each other in a wired manner with the second rail of the slide rail assembly being moved to an open position in response to an elastic force of an elastic member according to the embodiment of the present invention;
FIG. 13 is a diagram showing one of the movable members on the cabinet body of the intelligent cabinet system being opened with one object being stored in the opened movable member according to the embodiment of the present invention;
FIG. 14 is a diagram showing a communication device of the intelligent cabinet system being installed with an application program with a screen of the communication device displaying functions of the application program according to the embodiment of the present invention;
FIG. 15 is a diagram showing the screen of the communication device displaying object information and position information according to the embodiment of the present invention;
FIG. 16 is a diagram showing the communication device having a camera module capable of capturing an identification feature of an object;
FIG. 17 is a flow chart of finding an object stored in the intelligent cabinet system according to the embodiment of the present invention; and
FIG. 18 is another flow chart of finding an object stored in the intelligent cabinet system according to the embodiment of the present invention.

### Detailed Description

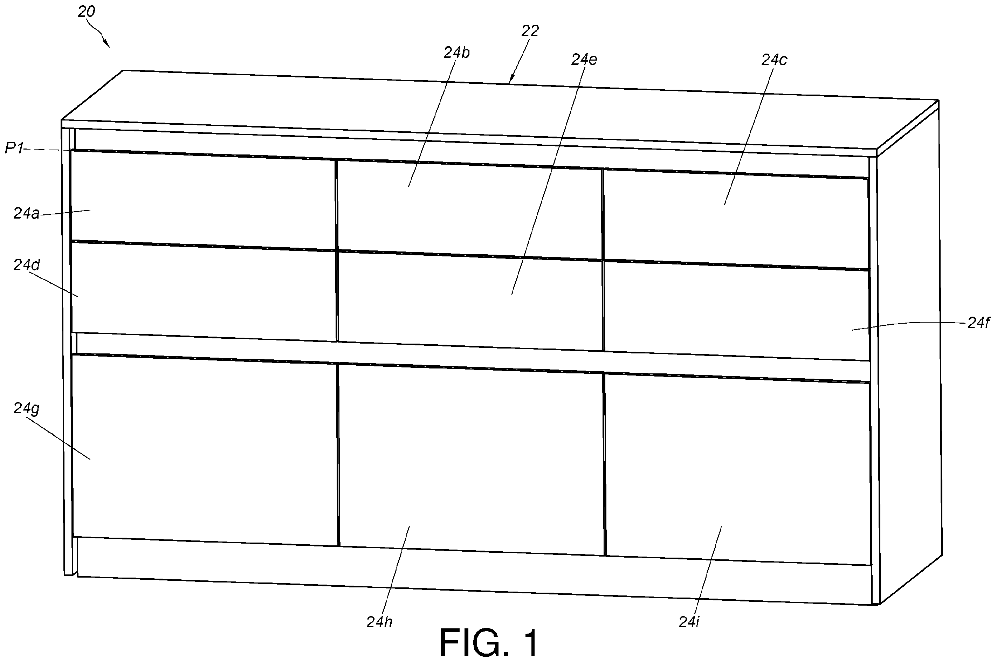

As shown in FIG. 1, an intelligent cabinet system 20 comprises a cabinet body 22 and a plurality of movable members arranged on the cabinet body 22 according to an embodiment of the present invention. The movable members can be drawers or door panels. In the present embodiment, the movable members are drawers, but the present invention is not limited thereto. Moreover, the intelligent cabinet system 20 has nine drawers, such as a first drawer 24a to a ninth drawer 24i. However, the number of the movable members is not limited by the embodiment. Furthermore, difference between the first drawer 24a to the sixth drawer 24f and the seventh drawer 24g to the ninth drawer 24i is only the size of the drawers.

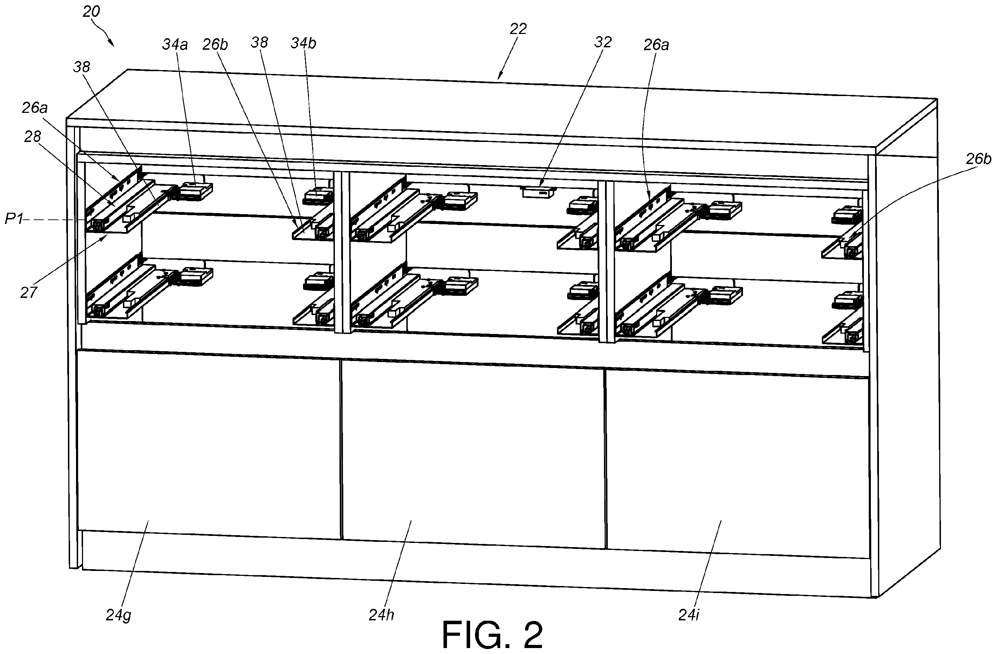

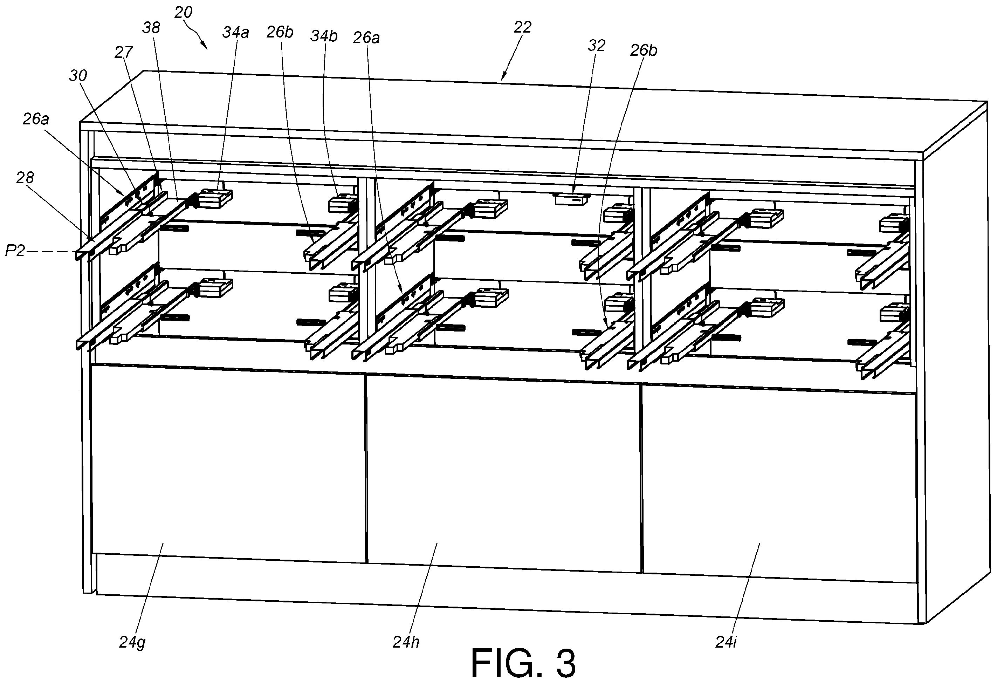

As shown in FIG. 2 and FIG. 3, the cabinet body 22 is formed with a plurality of accommodating spaces configured to correspondingly accommodate the drawers. In FIG. 2 and FIG. 3, the first drawer 24a to the sixth drawer 24f have been removed from the accommodating spaces of the cabinet body 22. Preferably, the intelligent cabinet system 20 further comprises a plurality of slide rail assemblies configured to correspondingly support the drawers. For example, a first slide rail assembly 26a and a second slide rail assembly 26b are paired and configured to support a left side and a right side of a bottom of a corresponding drawer respectively. The first slide rail assembly 26a and the second slide rail assembly 26b have substantially identical structural configuration, but the present invention is not limited thereto.

Each of the slide rail assemblies (such as the first slide rail assembly 26a or the second slide rail assembly 26b) comprises a first rail 27 and a second rail 28 longitudinally movable relative to each other. The first rail 27 is configured to be mounted (such as fixed) to a predetermined wall of the cabinet body 22, and the second rail 28 is configured to carry the drawer. The second rail 28 is movable between a retracted position P1 (as shown in FIG. 2) and an open position P2 (as shown in FIG. 3) relative to the first rail 27, so as to improve smoothness of movement of the drawer between the retracted position P1 and the open position P2 relative to the cabinet body 22. Preferably, each of the slide rail assemblies (such as the first slide rail assembly 26a or the second slide rail assembly 26b) further comprises a third rail 30 movably mounted between the first rail 27 and the second rail 28 in order to extend a traveling distance of the second rail 28 relative to the first rail 27.

The intelligent cabinet system 20 further comprises a control device 32 (or a controller) and a plurality of electronic modules. The control device 32 is arranged on the cabinet body 22. For example, the control device 32 is arranged on a predetermined part inside the accommodating space of the cabinet body 22, but the present invention is not limited thereto. The electronic modules are arranged in pairs. For example, a first electronic module 34a and a second electronic module 34b are paired to be arranged adjacent to the left side and the right side of the bottom of the corresponding drawer respectively. The first electronic module 34a and the second electronic module 34b have substantially identical structural configuration, and each of the electronic modules (such as the first electronic module 34a or the second electronic module 34b) is correspondingly arranged on an extension part 38 of a first rail 27 of the slide rail assembly (such as the first rail assembly 26a or the second rail assembly 26b) .

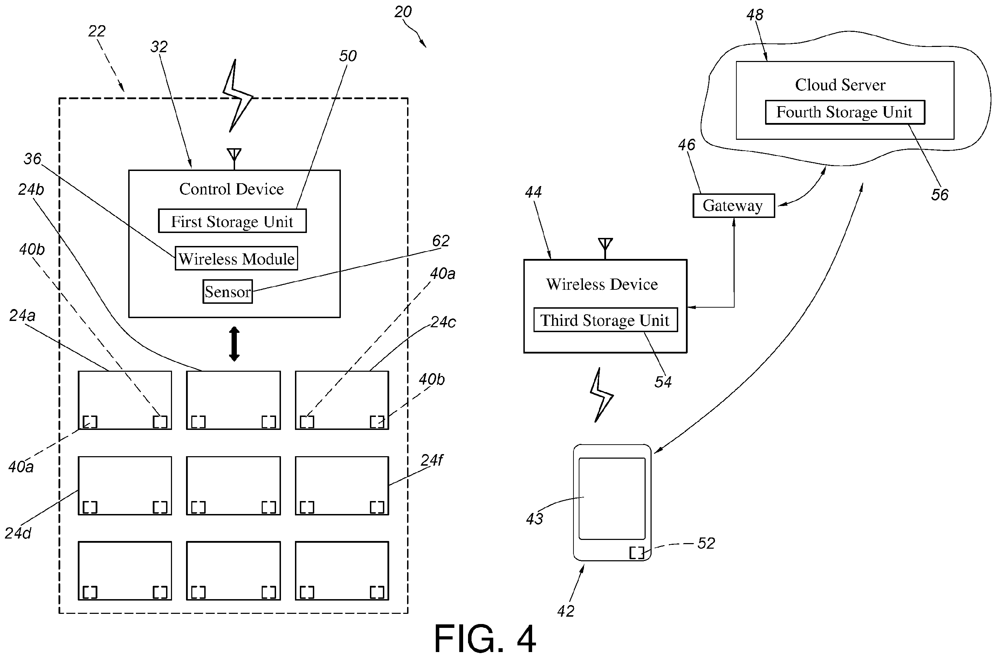

As shown in FIG. 4, the intelligent cabinet system 20 further comprises a plurality of control units arranged on the cabinet body 22. For example, a first control unit 40a and a second control unit 40b are paired to be arranged adjacent to the left side and the right side of the bottom of the corresponding drawer respectively. The first control unit 40a and the second control unit 40b have substantially identical structural configuration. In the present embodiment, each of the first control units 40a is integrated into a corresponding first electronic module 34a, and each of the second control units 40b is integrated into a corresponding second electronic modules 34b, but the present invention is not limited thereto. Each of the control units is electrically connected to a corresponding electronic module. For example, the first control unit 40a is electrically connected to the corresponding first electronic module 34a, and the second control unit 40b is electrically connected to the corresponding second electronic module 34b. Furthermore, the first control units 40a and the second control units 40b are electrically connected to the control device 32. Preferably, the first control units 40a and the second control units 40b are electrically connected to the control device 32 in a wired manner.

The intelligent cabinet system 20 further comprises a communication device 42. Preferably, the intelligent cabinet system 20 further comprises a wireless device 44, a gateway 46, and a cloud server 48.

The communication device 42, the wireless device 44 and the control device 32 are configured to be linked to each other through wireless communication. In the present embodiment, the communication device 42 is configured to establish a wireless communication link with the control device 32 through the wireless device 44, but the present invention is not limited thereto. The wireless device 44 can be a wireless access point or a wireless router, but the present invention is not limited thereto. In the present embodiment, the communication device 42 is configured to establish a communication link with the control device 32 through the wireless device 44 by using Wi-Fi technology. In other embodiment, the communication device 42 can establish a communication link with the control device 32 by using Bluetooth technology.

In addition, the wireless device 44 and the gateway 46 are configured to be linked to each other, such that application environment of the intelligent cabinet system 20 can be extended from a local area network (LAN) to a wide area network (WAN). Furthermore, the wireless device 44 is configured to establish a communication link with the cloud server 48 through the gateway 46. On the other hand, the communication device 42 is configured to establish a communication link with the cloud server 48 through the wireless device 44 and the gateway 46. Alternatively, the communication device 42 can establish a communication link with the cloud server 48 by using mobile communication technology, such as fourth generation mobile communication technology (4G) or fifth generation mobile communication technology (5G). The communication device 42 can be a smart phone or a tablet computer, but the present invention is not limited thereto. Preferably, the communication device 42 is installed with an application program.

Preferably, the control device 32 comprises a first storage unit 50 configured to store a set of predetermined data of the intelligent cabinet system 20. The set of predetermined data can comprises object information and/or position information. For example, the object information is information of a specific object stored in the intelligent cabinet system 20; and the position information is information of the corresponding drawer storing the aforementioned specific object. Moreover, the set of predetermined data can comprise a state of each of the drawers (such as a retracted state or an open state) . The electronic module (such as the first electronic module 34a or the second electronic module 34b) can comprises a sensing unit configured to determined the drawer is in the retracted state when sensing that the second rail 28 is located at the retracted position P1 relative to the first rail 27, and configured to determined the drawer is in the open state when sensing that the second rail 28 is no longer located at the retracted position P1 relative to the first rail 27. Moreover, the set of predetermined data can comprise system power information of the intelligent cabinet system 20 (such as residual power information of the intelligent cabinet system 20) . However, the content of the set of predetermined data is not limited thereto.

Preferably, the first storage unit 50 can be a memory card (such as a microSD memory Card), but the present invention is not limited thereto.

Preferably, the communication device 42 comprises a second storage unit 52, the wireless device 44 comprises a third storage unit 54, and the cloud server 48 comprises a fourth storage unit 56. The third storage unit 54 can be a memory card or a USB flash drive, but the present invention is not limited thereto.

Preferably, the control device 32 further comprises a wireless module 36. The communication device 42 is configured to establish a wireless communication link with the wireless module 36 of the control device 32, such that the set of predetermined data stored in the first storage unit 50 of the control device 32 can be synchronously updated and stored in the second storage unit 52 of the communication device 42.

Preferably, the wireless device 44 is configured to establish a wireless communication link with the wireless module 36 of the control device 32 through operating the communication device 42, such that the set of predetermined data stored in the first storage unit 50 of the control device 32 can be synchronously updated and stored in the third storage unit 54 of the wireless device 44.

Preferably, the wireless device 44 is configured to establish a wireless communication link with the cloud server 48 through operating the communication device 42, such that the set of predetermined data stored in the third storage unit 54 of the wireless device 44 can be synchronously updated and stored in the fourth storage unit 56 of the cloud server 48. Moreover, the set of predetermined data stored in the second storage unit 52 of the communication device 42 can be synchronously updated and stored in the third storage unit 54 of the wireless device 44. Other user can use another communication device to establish a communication link with the wireless device 44 to download the set of predetermined data stored in the third storage unit 54 of the wireless device 44, in order to obtain information of objects stored in the drawers of the intelligent cabinet system 20.

Therefore, the set of predetermined data stored in the control device 32, the communication device 42, the wireless device 44 and the cloud server 48 can be synchronously updated with each other, such that the communication device 42 carried by the user can execute the application program to establish the wireless communication link with the control device 32, the wireless device 44 and/or the cloud server 48 whether indoors or outdoors, in order to obtain the latest set of predetermined data. For example, when the user is indoors, the communication device 42 can establish the wireless communication link with the wireless device 44 or the control device 32 in order to obtain the latest set of predetermined data; when the user is outdoors, the communication device 42 can establish the wireless communication link with the cloud server 48 in order to obtain the latest set of predetermined data, but the present invention is not limited thereto.

Moreover, an administrator of the intelligent cabinet system 20 (such as the user of the communication device 42) can use the communication device 42 to provide permission to allow another communication device to access the intelligent cabinet system 20. For example, the communication device 42 can provide a barcode or a QR-code to another communication device for obtaining relevant settings of the intelligent cabinet system 20, such that a user using the other communication device can quickly operate the intelligent cabinet system 20.

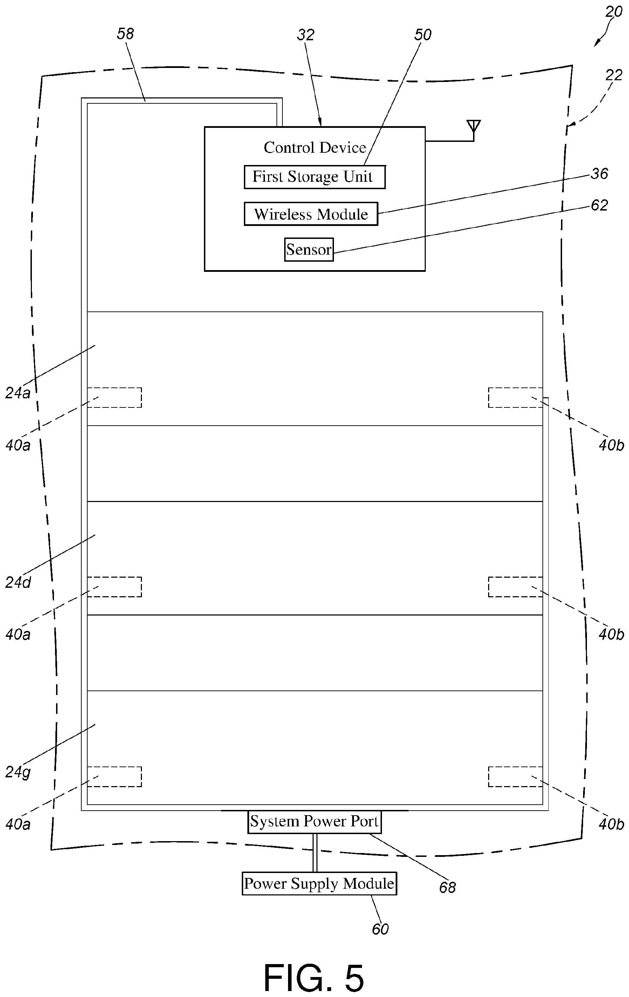

As shown in FIG. 5, each of the control units (such as the first control unit 40a or the second control unit 40b) is electrically connected to the control device 32 through a cable 58 (such as a Controller Area Network bus (CAN bus) or an RS485 communication cable). Specifically, the control units (such as the first control units 40a and the second control units 40b), the electronic modules (such as the first electronic modules 34a and the second electronic modules 34b) and the control device 32 are electrically connected to each other through the interference-resistant cables 58 (such as the Controller Area Network buses or the RS485 communication cables). Furthermore, signals or packets transmitted between the control device 32, the control units and the electronic modules can be encrypted either dynamically or statically in order to avoid interception and decryption of the signals or packets.

In addition, each of the drawers (such as the first drawer 24a to the ninth drawer 24i) works with a corresponding pair of the first control unit 40a and the second control unit 40b. The control device 32 is configured to control each of the drawers to be opened from the retracted state through the control units (such as the corresponding pair of the first control unit 40a and the second control unit 40b) and the corresponding electronic modules (such as the first electronic module 34a and the second electronic module 34b).

Moreover, each of the drawers and its corresponding first control unit 40a and second control unit 40bhas an identification code. For example, the identification code of the first drawer 24a can be set to "11111", the identification code of the first control unit 40a corresponding to the first drawer 24a can be set to "111111", and the identification code of the second control unit 40b corresponding to the first drawer 24a can be set to "011111". The first digit "1" of the identification code of the first control unit 40a represents the left side, and the second to sixth digits "11111" of the identification code of the first control unit 40a represent that the first control unit 40a corresponds to the first drawer 24a. In other words, the identification code "111111" can be interpreted as the control unit responsible for the left side of the first drawer 24a. On the other hand, the first digit "0" of the identification code of the second control unit 40b represents the right side, and the second to sixth digits "11111" of the identification code of the second control unit 40b represent that the second control unit 40b corresponds to the first drawer 24a. In other words, the identification code "011111" can be interpreted as the control unit responsible for the right side of the first drawer 24a. Accordingly, the control device 32 can determine which pair of the first control unit 40a and the second control unit 40b to notify according to the identification code of the drawer, in order to further control the corresponding pair of electronic modules. However, the format of the identification code is not limited by the present embodiment. The user can also use the application on the communication device 42 to write exclusive or customized identification codes into the first control unit 40a and the second control unit 40b.

Therefore, the control device 32 is configured to establish the communication links with the wireless device 44, the communication device 42, and the cloud server 48 in a wireless manner, and the control device 32 is configured to establish the communication links with the control units (such as the first control units 40a and the second control units 40b) and the electronic modules (such as the first electronic modules 34a and the second electronic modules 34b) in a wired manner.

Preferably, the intelligent cabinet system 20 further comprises a power supply module 60 configured to supply power to a system power port 68. The system power port 68 is electrically connected to the control device 32, the control units (such as the first control units 40a and the second control units 40b) and the electronic modules (such as the first electronic modules 34a and the second electronic modules 34b) through the cable 58. As such, the power supply module 60 can provide power required by the control device 32, the control units (such as the first control units 40a and the second control units 40b) and the electronic modules (such as the first electronic modules 34a and the second electronic modules 34b) through the system power port 68. The power supply module 60 is also electrically connected to the system power port 68 in a wired manner (such as through the Controller Area Network bus (CAN bus) or the RS485 communication cable) .

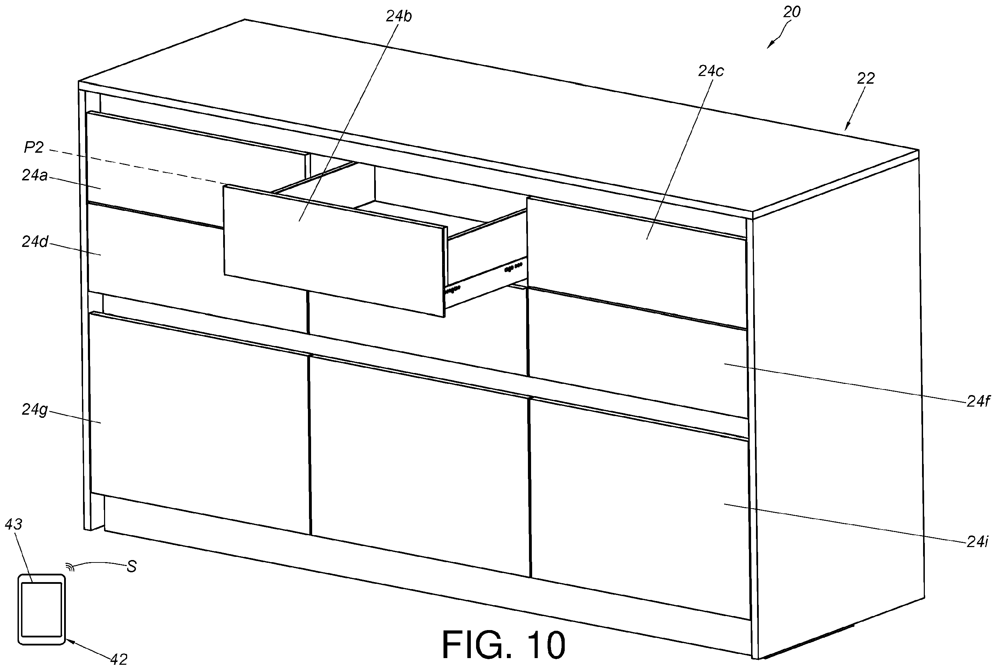

Preferably, the intelligent cabinet system 20 further comprises a sensor 62 arranged on the cabinet body 22. The sensor 62 is electrically connected to the control device 32. In the present embodiment, the sensor 62 is integrated into the control device 32. The sensor 62 is configured to sense whether someone is approaching the cabinet body 22. When the sensor 62 senses that someone is approaching the cabinet body 22, the intelligent cabinet system 20 is configured to be switched from a power saving mode to an operating mode, such that the wireless module 36 of the control device 32 is configured to be activated to receive a predetermined signal S from the communication device 42 (please also refer to FIG. 10) . For example, when the intelligent cabinet system 20 is in the power saving mode, the control device 32 is configured to control the power supply module 60 to only supply power to the sensor 62 without supplying power to other components (such as the wireless module 36, the control units and the electronic modules, etc.); and when the intelligent cabinet system 20 is in the operating mode, the control device 32 is configured to control the power supply module 60 to supply power to all of the related components, but the present invention is not limited thereto. Therefore, the arrangement of the sensor 62 can allow the intelligent cabinet system 20 to be switched from the operating mode to the power saving mode in order to reduce power consumption. In other words, when the intelligent cabinet system 20 is in the power saving mode, the intelligent cabinet system 20 can have lower power consumption.

Preferably, the sensor 62 is a radar sensor. The radar sensor has several frequency bands applicable to several frequency resolutions required by different environments. Diversity of objects stored in the drawers may affect reflection and transmission of electromagnetic waves. In the present embodiment, the sensor 62 uses electromagnetic waves with a frequency of 60GHz for sensing, since the electromagnetic wave with the frequency of 60GHz has a shorter wavelength, such that it is easier to diffract and penetrate obstacles. In the present embodiment, the sensor 62 is a radar sensor, but the present invention is not limited thereto. The sensor 62 can be other types of sensors.

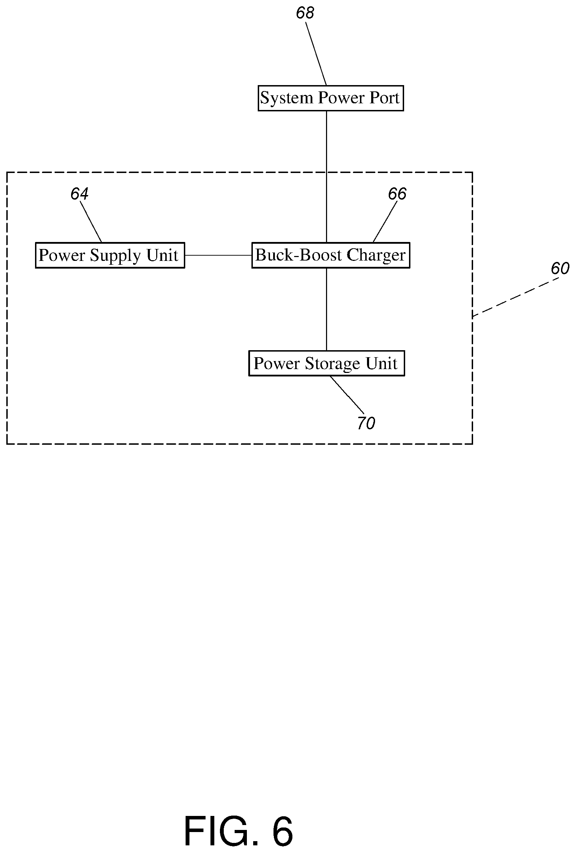

As shown in FIG. 6, the power supply module 60 comprises a power supply unit 64 and a buck-boost charger 66 (or a buck-boost power circuit).

The power supply unit 64 is configured to supply power to the buck-boost charger 66 in a wired or wireless manner, and the buck-boost charger 66 is configured to adjust (such as increasing or decreasing voltage) and transmit the power from the power supply unit 64 to the system power port 68, in order to provide power to the control device 32, the control units (such as the first control units 40a and the second control units 40b) and the electronic modules (such as the first electronic modules 34a and the second electronic modules 34b).

Preferably, the power supply module 60 further comprises a power storage unit 70 working as a backup power supply for the intelligent cabinet system 20. The power storage unit 70 can be a battery pack composed of a plurality of batteries connected in series. However, the number of batteries in the present invention is not limited.

Preferably, the power supply unit 64, the buck-boost charger 66, the system power port 68 and the power storage unit 70 are electrically connected to each other.

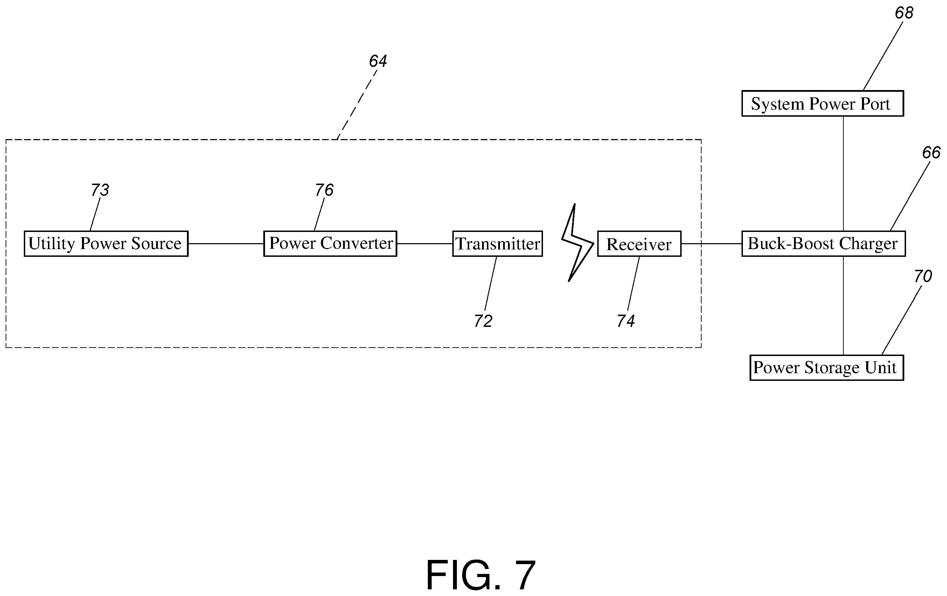

FIG. 7 shows a first type of the power supply unit 64, such as a wireless type power supply unit. Furthermore, the power supply unit 64 comprises a transmitter 72 and a receiver 74. Preferably, the transmitter 72 is arranged outside the cabinet body 22, and the receiver 74 is arranged inside the cabinet body 22. The receiver 74 is electrically connected to the buck-boost charger 66 in a wired manner. Preferably, the cabinet body 22 can be made of wood or other non-metallic materials, but the present invention is not limited thereto. If the cabinet body 22 is made of a metal material, a connector can be mounted at an appropriate position to be connected with an inductor for receiving electromagnetic energy, and then the electromagnetic energy is transmitted to a receiving board inside the cabinet body 22 in order to power the intelligent cabinet system 20. Such arrangement is applicable to a movable iron cabinet.

The transmitter 72 is electrically connected to a utility power source 73. For example, the power supply unit 64 further comprises a power converter 76 electrically connected between the transmitter 72 and the utility power source 73. The power converter 76 is configured to convert AC power provided by the utility power source 73 into DC power. The transmitter 72 comprises a first coil. The transmitter 72 is configured to use the first coil to generate and transmit electromagnetic waves to a second coil of the receiver 74 according to the power from the power converter 76. The receiver 74 is configured to convert the electromagnetic waves received by the second coil into electricity and transmits it to the buck-boost charger 66. A power IC of the buck-boost charger 66 then adjusts the power transmitted from the receiver 74 to have a proper voltage value required by the operation of the intelligent cabinet system 20, and further transmits the adjusted power to the system power port 68. In addition, the adjusted power from the buck-boost charger 66 can also be stored in the power storage unit 70. In other words, the power storage unit 70 can be charged by the buck-boost charger 66. When the utility power source 73 suddenly stops supplying AC power (i.e., a power outage occurs), the power storage unit 70 is configured to provide power to the system power port 68, in order to further provide power to the control device 32, the control units (such as the first control units 40a and the second control units 40b) and the electronic modules (such as the first electronic modules 34a and the second electronic modules 34b).

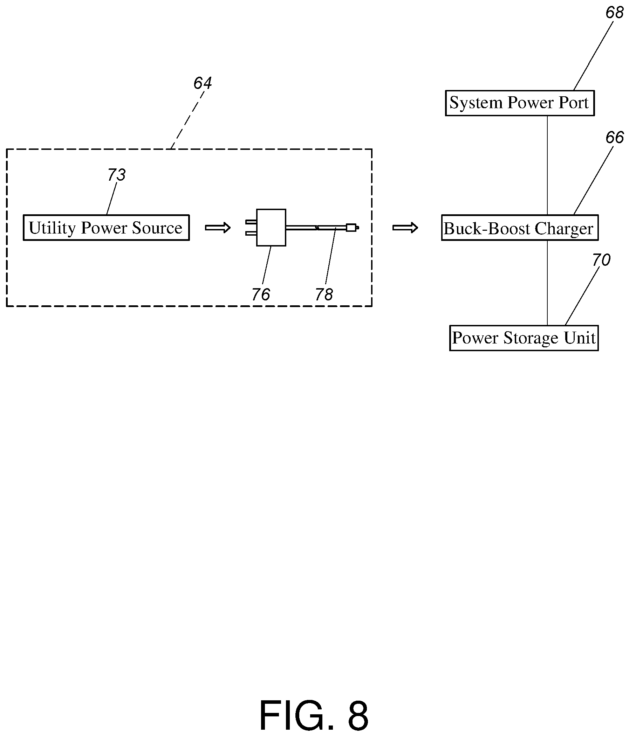

FIG. 8 shows a second type of the power supply unit 64, such as a wired type power supply unit. Moreover, the power supply unit 64 comprises the power converter 76 electrically connected to the utility power source 73. The power converter 76 is configured to convert AC power provided by the utility power source 73 into DC power, and then transmit the DC power to the buck-boost charger 66 through a transmission cable 78 with a DC connector or a USB Type-C connector. The buck-boost charger 66 is configured to adjust and transmit the power from the power supply unit 64 to the system power port 68. Moreover, the power storage unit 70 can also be charged by the buck-boost charger 66.

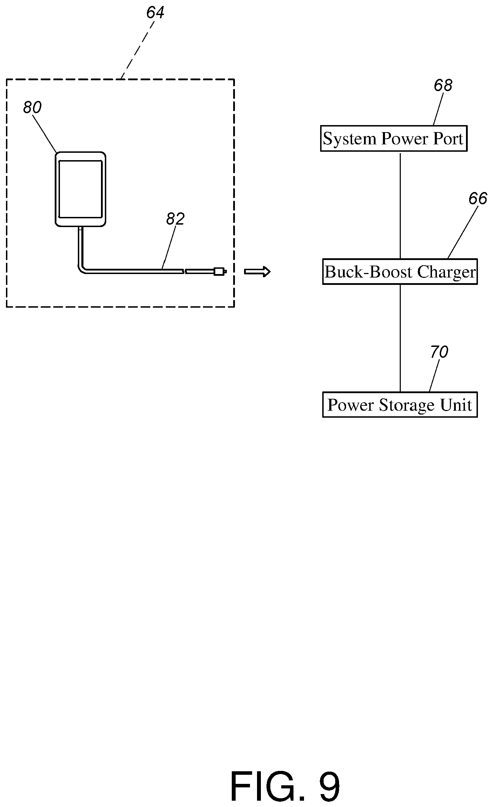

FIG. 9 shows a third type of the power supply unit 64, such as a wired type power supply unit. Moreover, the power supply unit 64 comprises an electronic device 80. The electronic device 80 is configured transmit power stored in the electronic device 80 to the buck-boost charger 66 through a predetermined transmission cable 82 (such as a USB Type-C transmission cable) . The buck-boost charger 66 is configured to adjust and transmit the power from the electronic device 80 to the system power port 68, in order to further provide power to the control device 32, the control units (such as the first control units 40a and the second control units 40b) and the electronic modules (such as the first electronic modules 34a and the second electronic modules 34b). Moreover, the power storage unit 70 can also be charged by the buck-boost charger 66. Preferably, the electronic device 80 can be a smart phone, a tablet computer, or a mobile power bank, but the present invention is not limited there to.

As shown in FIG. 10, the communication device 42 is configured to transmit the predetermined signal S, such as a control signal, through the application program in order to control one of the drawers on the cabinet body 22 to be open. For example, the second drawer 24b is moved from the retracted position P1 to the open position P2 to be opened.

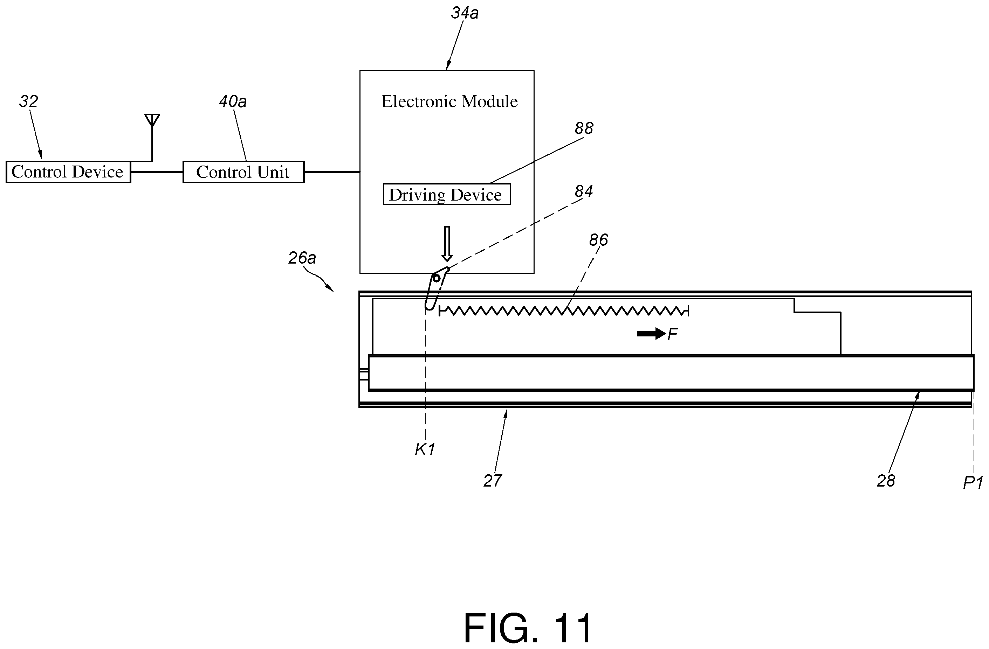

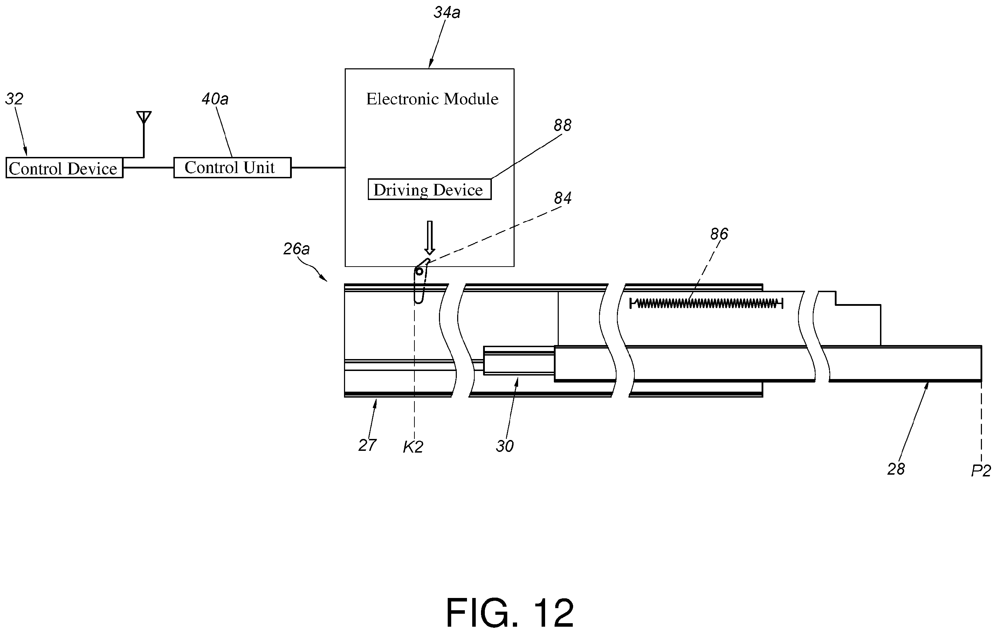

FIG. 11 and FIG. 12 illustrate processes of opening the drawer (such as the second drawer 24b) on the cabinet body 22. FIG. 11 and FIG. 12 only show the first electronic module 34a, the first control unit 40a and the first slide rail assembly 26a corresponding to the second drawer 24b for illustration, but the second electronic module 34b, the second control unit 40b and the second slide rail assembly 26b corresponding to the second drawer 24b also operate in the same or similar manner. Furthermore, the first electronic module 34a, the first control unit 40a and the control device 32 are electrically connected to each other through the Controller Area Network buses or the RS485 communication cables. The first electronic module 34a comprises a driving device 88 configured to drive a driving member 84 to move. On the other hand, the first slide rail assembly 26a is a push-open slide rail assembly. Specifically, the first slide rail assembly 26a further comprises an elastic member 86. When the second rail 28 of the first slide rail assembly 26a carrying the drawer (such as the second drawer 24b in FIG. 1) is located at the retracted position P1 relative to the first rail 27, the second drawer 24b is correspondingly located at the retracted position P1 relative to the cabinet body 22. As such, the elastic member 86 is configured to accumulate a predetermined elastic force F (as shown in Figure 11) .

The control device 32 is configured to receive the predetermined signal S from the communication device 42 (the content of the predetermined signal S comprises the identification code of the second drawer 24b and/or comprises the identification code of the first control unit 40a corresponding to the second drawer 24b). When the control device 32 receives the predetermined signal S, the control device 32 is configured to notify the first control unit 40a corresponding to the second drawer 24b according to the identification code in the predetermined signal S, in order to control the driving device 88 to drive the driving member 84 to move to switch from a first predetermined state K1 (as shown in FIG. 11) to a second predetermined state K2 (as shown in FIG. 12), so as to allow the second drawer 24b to be moved away from the retracted position P1.

Preferably, when the driving member 84 is moved to switch from the first predetermined state K1 to the second predetermined state K2, the predetermined elastic force F of the elastic member 86 is released to the second rail 28, such that the second rail 28 is configured to be driven to move the second drawer 24b from the retracted position P1 (as shown in FIG. 11) to the open position P2 (as shown in FIG. 12) in response to the predetermined elastic force F released by the elastic member 86. During a process of the driving member 84 being moved to switch from the first predetermined state K1 to the second predetermined state K2, the driving member 84 is configured to activate the elastic member 86 to release the predetermined elastic force F. For example, the driving member 84 can directly contact the elastic member 86 in order to activate the elastic member 86 to release the predetermined elastic force F; or the driving member 84 can indirectly activate a predetermined device locking the elastic member 86 through other predetermined components, such that the elastic member 86 can release the predetermined elastic force F.

Preferably, the driving device 88 is a motor or an electromagnetic actuator, but the present invention is not limited thereto. For example, when the driving device 88 is a motor, a rotating shaft of the driving device 88 can directly drive the driving member 84 to move to switch from the first predetermined state K1 to the second predetermined state K2, or the rotating shaft of the driving device 88 can indirectly drive the driving member 84 through related components to move to switch from the first predetermined state K1 to the second predetermined state K2; when the driving device 88 is an electromagnetic actuator, the driving device 88 can drive related components to move the driving member 84 to switch from the first predetermined state K1 to the second predetermined state K2 by electromagnetic force.

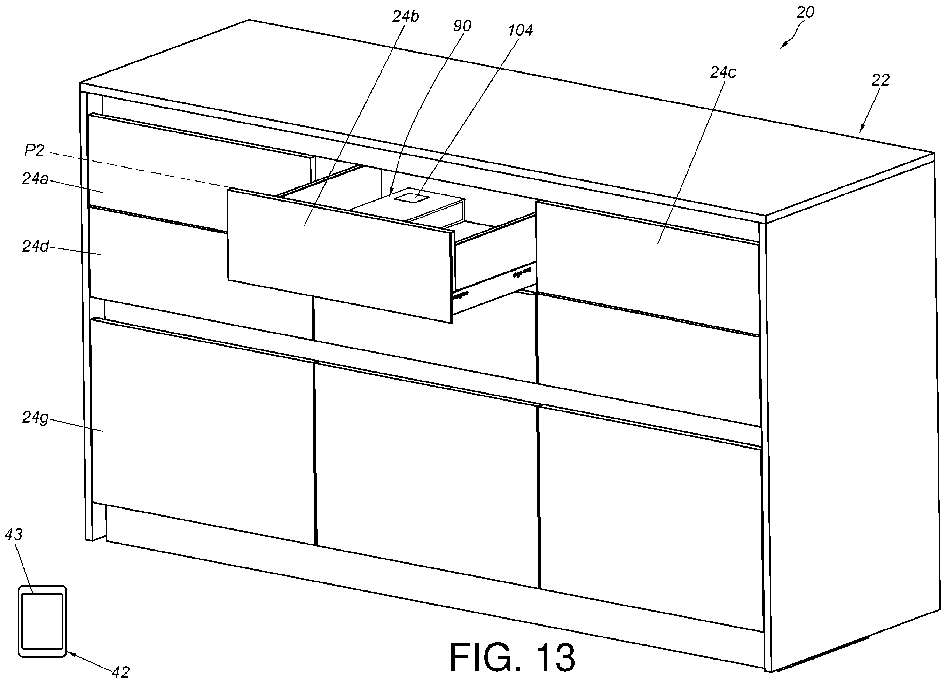

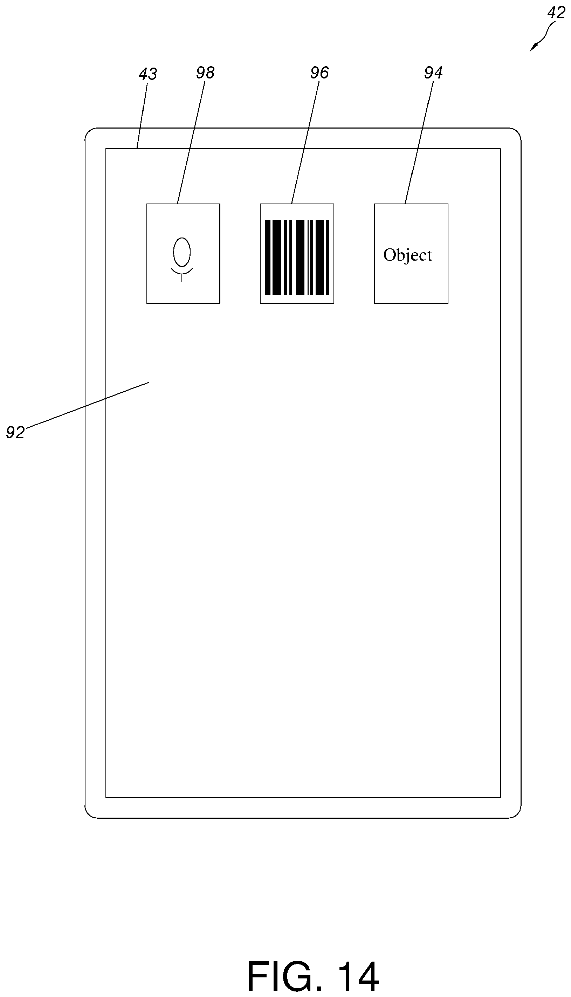

As shown in FIG. 13 to FIG. 15, when the second drawer 24b is located at the open position P2 relative to the cabinet body 22, the user can place and store a first predetermined object 90 (such as a piece of soap shown in Figure 13, but the present invention is not limited thereto) in the second drawer 24b. A screen 43 (such as a touch screen) of the communication device 42 is configured to display an operating interface 92 of the application program to provide related functions for the user to select. In the present embodiment, the operating interface 92 provides an object function 94, a barcode function 96 and a voice function 98 (as shown in FIG. 14), but the present invention is not limited thereto. Moreover, the second drawer 24b is only illustrated as an example, and the user can open another drawer to place and store the first predetermined object 90 or other objects.

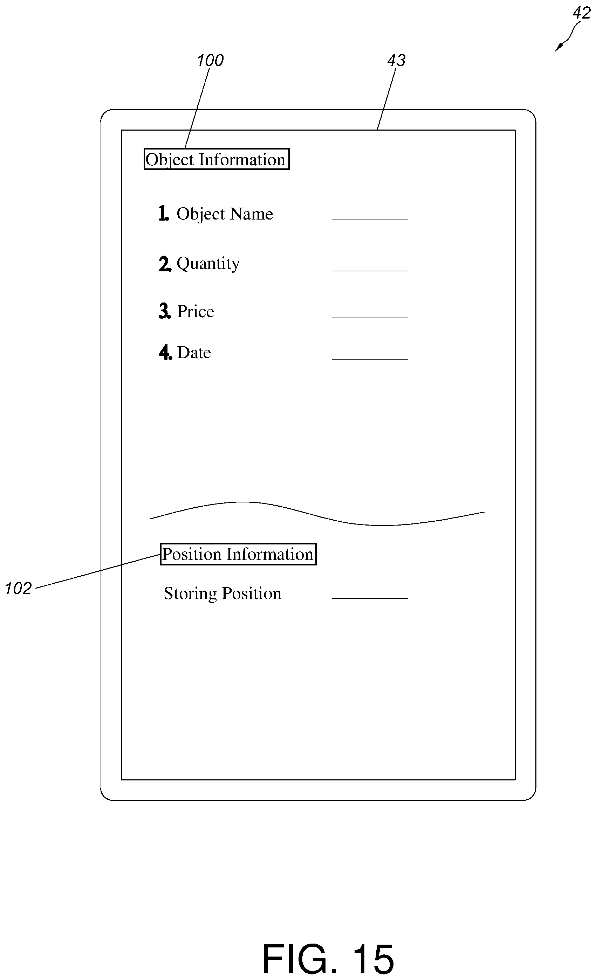

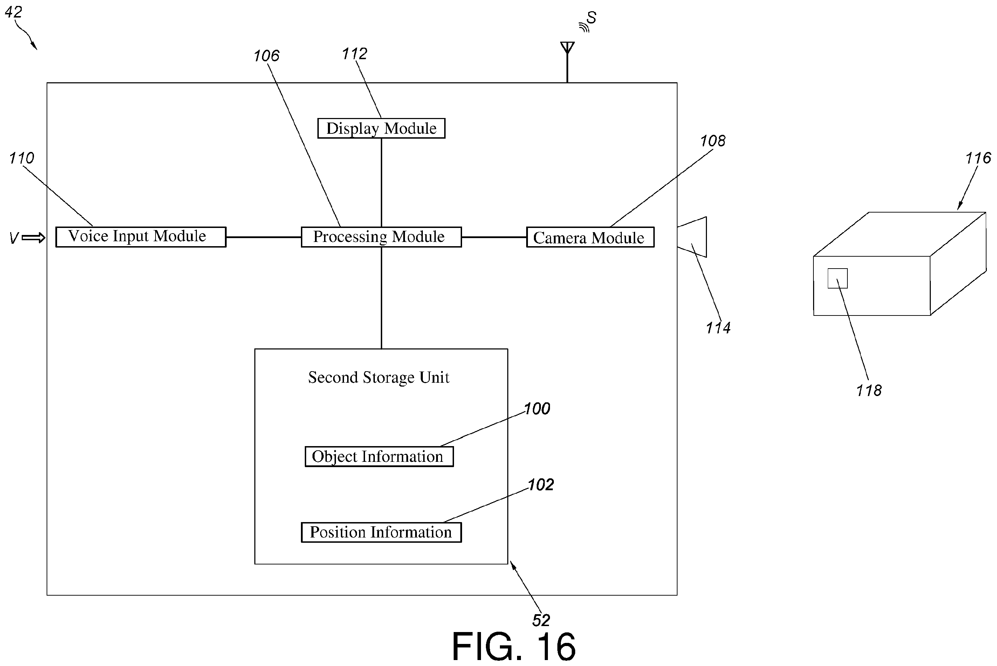

Furthermore, the user can input object information 100 and position information 102 through the object function 94 (as shown in FIG. 15). The object information 100 and the position information 102 can be pre-stored in the second storage unit 52 of the communication device 42 (please also refer to FIG. 16) as part of the set of predetermined data. When the communication device 42 establishes the wireless communication link with the control device 32, the set of predetermined data stored in the second storage unit 52 can be synchronously updated and stored in the first storage unit 50 of the control device 32 on the cabinet body 22. In other words, the first storage unit 50 and the second storage unit 52 have pre-stored the object information 100 and the position information 102.

Preferably, the object information 100 comprises information of object name, quantity, price and/or date of the first predetermined object 90 (as shown in FIG. 15). In the present embodiment, since the first predetermined object 90 is placed and stored in the second drawer 24b and the second drawer 24b can be further moved to the retracted position P1 to be closed (as shown in FIG. 1), the user can input information of the second drawer 24b to be stored as the position information 102 of the first predetermined object 90. After manually inputting (or editing) the object information 100 and the position information 102, the user can select an save option in order to stored the object information 100 and the position information 102 as part of the set of predetermined data in the second storage unit 52, so as to record that the first predetermined object 90 has been stored in the second drawer 24b.

Preferably, the first predetermined object 90 has a first identification feature 104 (as shown in FIG. 13), such as a barcode or a QR-code, but the present invention is not limited thereto. The first identification feature 104 has relevant information of the first predetermined object 90, such as the object name and the price of the first predetermined object 90.

As shown in FIG. 16, the communication device 42 comprises a processing module 106, the second storage unit 52, a camera module 108, a voice input module 110, and a display module 112 electrically connected to each other. The processing module 106 is a central processing unit of the communication device 42; the second storage unit 52 is a memory; the camera module 108 comprises a lens 114; the voice input module 110 is configured to receive a voice input from the user; and the display module 112 comprises the screen 43 (please also refer to FIG. 15). The communication device 42 is configured to find objects stored in the intelligent cabinet system 20.

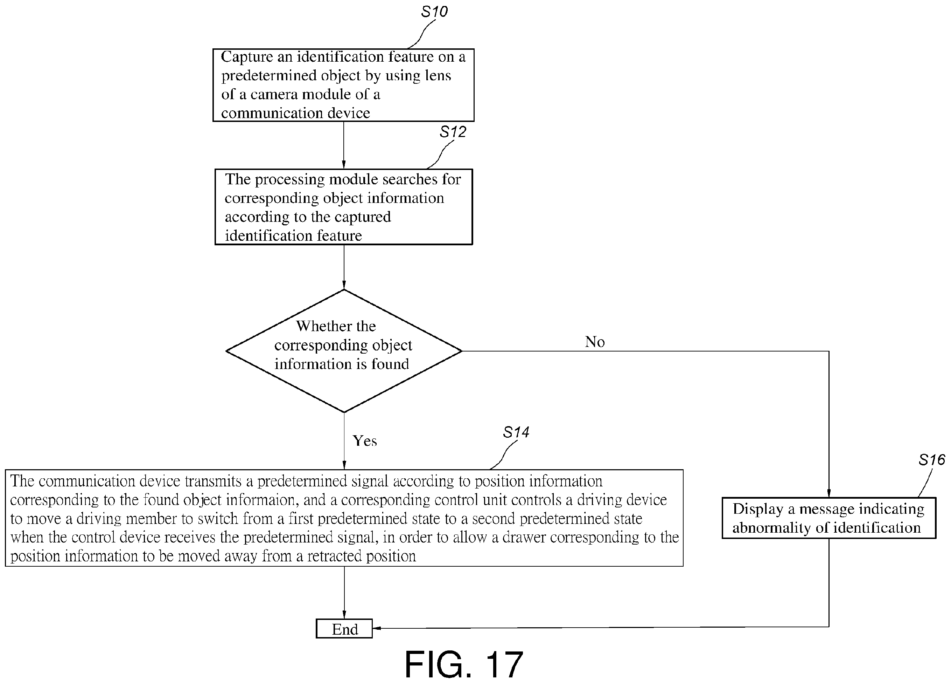

As shown in FIG. 16 and FIG. 17, when the user forgets which drawer on the cabinet body 22 the first predetermined object 90 is placed and stored in, the user can try to find the first predetermined object 90 by scanning a barcode (or a QR-code) on an outer box of an object that is the same as the first predetermined object 90.

Furthermore, the user can walk to a proper position close to the cabinet body 22. Accordingly, when the sensor 62 detects that the user is approaching the cabinet body 22, the intelligent cabinet system 20 is configured to be switched from the power saving mode to the operating mode. A method of finding objects of the intelligent cabinet system 20 comprises the following steps:
Step S10: Capture an identification feature on a predetermined object by using the lens of the camera module of the communication device. In step S10, the user can select the barcode function 96 of the application program of the communication device 42 (as shown in FIG. 14), and the camera module 108 of the communication device 42 is turned on to capture (or scan) a second identification feature 118 on a second predetermined object 116 that is the same as the first identification feature 104 of the aforementioned first predetermined object 90 through the lens 114. The second identification feature 118 can be a barcode (or a QR-code), but the present invention is not limited thereto. The second identification feature 118 has relevant information of the second predetermined object 116, such as the object name or the price of the second predetermined object 116. On the other hand, the identification feature is not limited to barcode or QR-code. The identification feature can also be text on an outer box of the object.
Step S12: The processing module 106 searches for corresponding object information according to the captured identification feature. In step S12, the processing module 106 searches for the corresponding object information 100 in the set of predetermined data pre-stored in the second storage unit 52 according to the captured second identification feature 118. For example, the processing module 106 is configured to obtain relevant information of the second predetermined object 116, such as the object name or the price of the second predetermined object 116, according to the captured second identification feature 118 on the second predetermined object 116. The processing module 106 then searches the set of predetermined data pre-stored in the second storage unit 52 for the object information 100 having the same object name (and/or the same price) . If the processing module 106 finds the object information 100 with the same object name (and/or the same price) in the set of predetermined data pre-stored in the second storage unit 52, then go to step S14; if the processing module 106 does not find the object information with the same object name (and/or the same price) in the set of predetermined data pre-stored in the second storage unit 52, then go to step S16.
Step S14: If the corresponding object information 100 is found, the communication device 42 transmits a predetermined signal S according to the position information 102 corresponding to the found object information 100, and the control device 32 notifies the corresponding control unit to control the driving device 88 to move the driving member 84 to switch from the first predetermined state K1 to the second predetermined state K2 when the control device 32 receives the predetermined signal S, in order to allow the drawer corresponding to the position information 102 to be moved away from the retracted position P1.

In step S14, when the processing module 106 determines that the pre-stored object name of the first predetermined object 90 is identical to the object name of the second predetermined object 116 (for example, both the object names are soap), it means that the corresponding object information is found. When the corresponding object information is found from the set of predetermined data, the processing module 106 is configured to obtain the position information of the first predetermined object 90 (such as the second drawer 24b) from the set of predetermined data. Thereafter, the screen 43 displays a corresponding option of the position information for the user to select by touch. When the user selects the corresponding option of the position information on the screen 43, the communication device 42 transmits the predetermined signal S (the content of the predetermined signal S comprises the identification code of the second drawer 24b and/or comprises the identification codes of the first control unit 40a and the second control unit 40b corresponding to the second drawer 24b) . When the control device 32 receives the predetermined signal S, the control device 32 notifies the first control unit 40a and the second control unit 40b corresponding to the second drawer 24b to control the driving devices 88 to move the driving members 84 to switch from the first predetermined state K1 (please also refer to FIG. 11) to the second predetermined state K2 (please also refer to FIG. 12), in order to allow the drawer (such as the second drawer 24b) storing the first predetermined object 90 to be moved away from the retracted position P1. For example, the second drawer 24b is configured to be opened to move from the retracted position P1 to the open position P2 in response to the predetermined elastic force F released to the second rail 28. Therefore, the user can find the first predetermined object 90 in the opened second drawer 24b.

Step S16: If the corresponding object information is not found, the screen 43 of the communication device 42 displays a message indicating abnormality of identification. For example, when the processing module 106 determines that the object name of the second predetermined object 116 is not identical to the object name of the pre-stored object information of the first predetermined object 90 (for example, the object name of the second predetermined object 116 is not soap), it means that the corresponding object information is not found. When the corresponding object information is not found from the set of predetermined data, the processing module 106 is configured to control the screen 43 to display a message indicating abnormality of identification. In other words, no drawer has stored an object with the same object name as the second predetermined object 116. Therefore, no drawer (the first drawer to ninth drawer 24a-24i) of the intelligent cabinet system 20 is going to be opened.

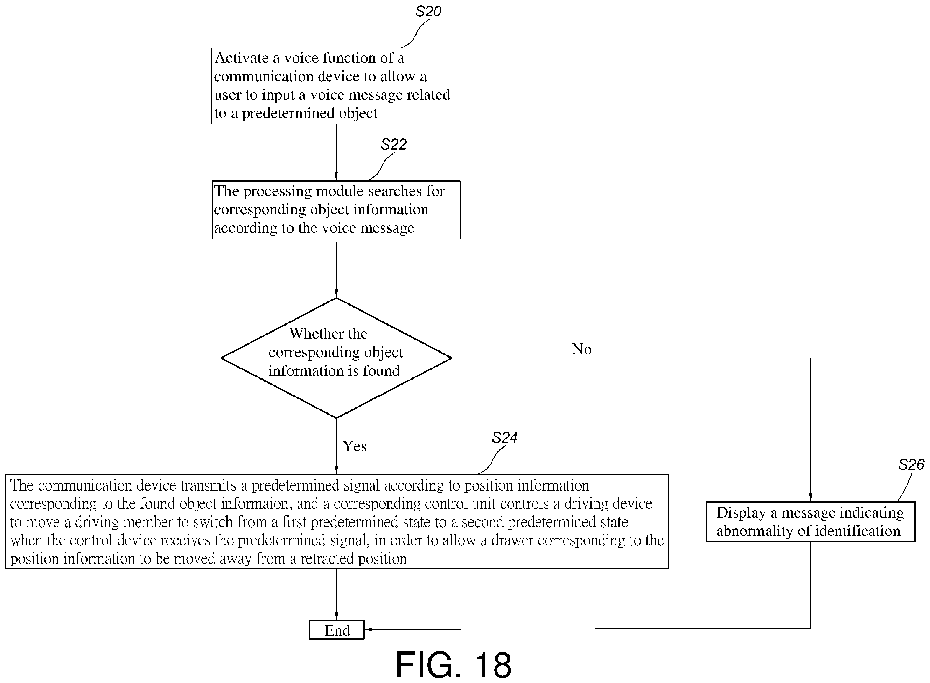

As shown in FIG. 16 and FIG. 18, in addition to the barcode scanning, the user can also try to find the first predetermined object 90 by voice. Another method of finding objects of the intelligent cabinet system 20 comprises the following steps:
Step S20: Activate the voice function of the communication device 42 to allow the user to input a voice message related to a predetermined object. In step S20, the user can select the voice function 98 of the application program of the communication device 42 (as shown in Figure 14), and the user can directly speak the object name of the first predetermined object 90 (for example, soap) to the voice input module 110 of the communication device 42, so that a voice receiving unit of the voice input module 110 is configured to receive the user's voice message V.
Step S22: The processing module 106 searches for corresponding object information according to the voice message. In step S22, the processing module 106 searches for the corresponding object information in the set of predetermined data (comprising the object information 100 and the position information 102) pre-stored in the second storage unit 52 according to the voice message V. For example, the processing module 106 is configured to obtain the object name in the voice message V according to a voice recognition technology. The processing module 106 then searches the set of predetermined data pre-stored in the second storage unit 52 for the object information 100 having the same object name. If the processing module 106 finds the object information 100 with the same object name in the set of predetermined data pre-stored in the second storage unit 52, then go to step S24; if the processing module 106 does not find the object information with the same object name in the set of predetermined data pre-stored in the second storage unit 52, then go to step S26.
Step S24: If the corresponding object information 100 is found, the communication device 42 transmits a predetermined signal S according to the position information 102 corresponding to the found object information 100, and the control device 32 notifies the corresponding control unit to control the driving device 88 to move the driving member 84 to switch from the first predetermined state K1 to the second predetermined state K2 when the control device 32 receives the predetermined signal S, in order to allow the drawer corresponding to the position information 102 to be moved away from the retracted position P1.

In step S24, when the processing module 106 determines that the object name of the object information 100 in the pre-stored set of predetermined data is identical to the object name recognized according to the voice message V (for example, soap), it means that the corresponding object information is found. When the corresponding object information is found from the set of predetermined data, the processing module 106 is configured to obtain the position information (such as the second drawer 24b) of the first predetermined object 90 from the set of predetermined data. Thereafter, the screen 43 displays a corresponding option of the position information for the user to select by touch. When the user selects the corresponding option of the position information on the screen 43, the communication device 42 transmits the predetermined signal S (the content of the predetermined signal S comprises the identification code of the second drawer 24b and/or comprises the identification codes of the first control unit 40a and the second control unit 40b corresponding to the second drawer 24b) . When the control device 32 receives the predetermined signal S, the control device 32 notifies the first control unit 40a and the second control unit 40b corresponding to the second drawer 24b to control the driving devices 88 to move the driving members 84 to switch from the first predetermined state K1 (please also refer to FIG. 11) to the second predetermined state K2 (please also refer to FIG. 12), in order to allow the drawer (such as the second drawer 24b) storing the first predetermined object 90 to be moved away from the retracted position P1. For example, the second drawer 24b is configured to be opened to move from the retracted position P1 to the open position P2 in response to the predetermined elastic force F released to the second rail 28. Therefore, the user can find the first predetermined object 90 in the opened second drawer 24b.

Step S26: If the corresponding object information is not found, the screen 43 of the communication device 42 displays a message indicating abnormality of identification. For example, when the processing module 106 determines that the object name of the object information 100 in the pre-stored set of predetermined data is not identical to the object name recognized according to the voice message V, it means that the corresponding object information is not found. When the corresponding object information is not found from the set of predetermined data, the processing module 106 is configured to control the screen 43 to display a message indicating abnormality of identification. In other words, no drawer stores the first predetermined object 90 (for example, the first predetermined object 90 has been taken away, and the object information and position information of the first predetermined object 90 have been deleted) . Therefore, no drawer (the first drawer to ninth drawer 24a-24i) of the intelligent cabinet system 20 is going to be opened.

Therefore, the intelligent cabinet system 20 according to the embodiment of the present invention has the following technical features:
1. The arrangement of the sensor 62 can allow the intelligent cabinet system 20 to have lower power consumption.
2. The power supply module 60 is configured to supply power to the system power port 68 of the intelligent cabinet system 20, and the power supply unit 64 of the power supply module 60 is electrically connected to the utility power source 73 in order to supply power in a wired or wireless manner. When the utility power source 73 stops supplying power, the power storage unit 70 can supply power to the system power port 68.
3. The control device 32 is arranged on the cabinet body 22. Moreover, the control device 32, the control units (such as the first control units 40a and the second control units 40b) and the electronic modules (such as the first electronic modules 34a and the second electronic modules 34b) are electrically connected to each other in a wired manner in order to avoid electromagnetic wave interference, so as to improve communication quality.

## Claims

1. An intelligent cabinet system (20), comprising:
a cabinet body (22);
a plurality of movable members arranged on the cabinet body (22) and movable between a retracted position and an open position relative to the cabinet body (22);
a control device (32) arranged on the cabinet body (22);
**characterized by**:
a control unit electrically connected to the control device (32);
an electronic module electrically connected to the control unit, the electronic module comprising a driving device (88) configured to drive a driving member (84) to move;
a power supply module (60) configured to supply power to at least one of the control device (32), the control unit and the electronic module;
a sensor (62) arranged on the cabinet body (22) and configured to sense whether a user is approaching the cabinet body (22); and
a communication device (42) configured to transmit a predetermined signal;
wherein when the control device (32) receives the predetermined signal, the control device (32) is configured to notify the control unit to control the driving device (88) to move the driving member (84) to switch from a first predetermined state to a second predetermined state, in order to allow one of the movable members to be moved away from the retracted position;
wherein when the sensor (62) senses that a user is approaching the cabinet body (22), the intelligent cabinet system (20) is configured to be switched from a power saving mode to an operating mode, such that the control device (32) is configured to be activated to receive the predetermined signal from the communication device (42).

2. The intelligent cabinet system of claim 1, **characterized in that** the movable members are drawers, the intelligent cabinet system (20) further comprises a plurality of slide rail assemblies configured to support the plurality of movable members correspondingly; wherein each of the slide rail assemblies comprises a first rail (27), a second rail (28) and an elastic member (86), the first rail (27) is configured to be mounted to the cabinet body (22), the second rail (28) is movable relative to the first rail (27) and configured to carry the movable member; wherein when the movable member is located at the retracted position relative to the cabinet body (22), the elastic member (86) is configured to accumulate a predetermined elastic force; wherein when the driving member (84) is moved to switch from the first predetermined state to the second predetermined state, the elastic member (86) is configured to release the predetermined elastic force, such that the second rail (28) is configured to drive the movable member to move from the retracted position to the open position in response to the predetermined elastic force released by the elastic member (86).

3. The intelligent cabinet system of claim 1 or 2, further **characterized by** a wireless device (44), wherein the communication device (42) is linked to the control device (32) through the wireless device (44).

4. The intelligent cabinet system of claim 3, **characterized in that** the communication device (42) is installed with an application program, and the communication device (42) is configured to transmit the predetermined signal through the application program.

5. The intelligent cabinet system of claim 4, **characterized in that** the application program has a voice function configured to find an object (90) stored in one of the movable members according to a user's voice.

6. The intelligent cabinet system of claim 4 or 5, **characterized in that** the application program has a barcode function configured to find an object (90) stored in one of the movable members according to a barcode scanned by a user.

7. The intelligent cabinet system of any of claims 1-6, **characterized in that** the control unit is electrically connected to the control device (32) in a wired manner.

8. The intelligent cabinet system of any of claims 1-7, **characterized in that** the control unit is electrically connected to the electronic module in a wired manner, and configured to control the driving device (88) to drive the driving member (84) .

9. The intelligent cabinet system of claim 3, **characterized in that** the control device (32) comprises a first storage unit (50) configured to store a set of predetermined data of the intelligent cabinet system (20).

10. The intelligent cabinet system of claim 9, **characterized in that** the communication device (42) is configured to establish a communication link with the control device (32), such that the set of predetermined data stored in the first storage unit (50) of the control device (32) is synchronously updated and stored in a second storage unit (52) of the communication device (42).

11. The intelligent cabinet system of claim 10, **characterized in that** the wireless device (44) is configured to establish a communication link with the control device (32) through operating the communication device (42), such that the set of predetermined data stored in the first storage unit (50) of the control device (32) is synchronously updated and stored in a third storage unit (54) of the wireless device (44).

12. The intelligent cabinet system of claim 11, further **characterized by** a cloud server (48), wherein the wireless device (44) is configured to establish a communication link with the cloud server (48) through operating the communication device (42), such that the set of predetermined data stored in the third storage unit (54) of the wireless device (44) is synchronously updated and stored in a fourth storage unit (56) of the cloud server (48) .

13. The intelligent cabinet system of claim 12, further **characterized by** a gateway (46), wherein the wireless device (44) is configured to establish the communication link with the cloud server (48) through the gateway (46) ; wherein the communication device (42) is configured to establish a communication link with the cloud server (48).

14. The intelligent cabinet system of any of claims 1-13, **characterized in that** the sensor (62) is electrically connected to the control device (32).

15. The intelligent cabinet system of any of claims 1-14, **characterized in that** the sensor (62) is a radar sensor.

## Patentansprüche

1. Intelligentes Schranksystem (20), welches aufweist:
einen Schrankkörper (22);
mehrere bewegbare Elemente, die an dem Schrankkörper (22) angeordnet sind und zwischen einer zurückgezogenen Position und einer geöffneten Position relativ zu dem Schrankkörper (22) bewegbar sind;
eine Steuervorrichtung (32), die an dem Schrankkörper (22) angeordnet ist;
**gekennzeichnet durch:**
eine Steuereinheit, die elektrisch mit der Steuervorrichtung (32) verbunden ist;
ein elektronisches Modul, das elektrisch mit der Steuereinheit verbunden ist, wobei das elektronische Modul eine Antriebsvorrichtung (88) aufweist, die konfiguriert ist, um ein Antriebselement (84) anzutreiben, um sich zu bewegen;
ein Energie-Zufuhr-Modul (60), das konfiguriert ist, um mindestens einem von der Steuervorrichtung (32), der Steuereinheit und dem elektronischen Modul Energie zuzuführen;
einen Sensor (62), der an dem Schrankkörper (22) angeordnet ist und konfiguriert ist, um zu erfassen, ob sich ein Benutzer dem Schrankkörper (22) nähert; und
eine Kommunikationsvorrichtung (42), die konfiguriert ist, um ein vorbestimmtes Signal zu übertragen;
wobei, wenn die Steuervorrichtung (32) das vorbestimmte Signal empfängt, die Steuervorrichtung (32) konfiguriert ist, um die Steuereinheit zu benachrichtigen, um die Antriebsvorrichtung (88) zu steuern, um das Antriebselement (84) zu bewegen, um von einem ersten vorbestimmten Zustand in einen zweiten vorbestimmten Zustand zu schalten, um zu ermöglichen, dass eines der bewegbaren Elemente aus der zurückgezogenen Position weg bewegt wird;
wobei, wenn der Sensor (62) erfasst, dass sich ein Benutzer dem Schrankkörper (22) nähert, das intelligente Schranksystem (20) konfiguriert ist, um von einem Energiesparmodus in einen Betriebsmodus geschaltet zu werden, sodass die Steuervorrichtung (32) konfiguriert ist, um aktiviert zu werden, um das vorbestimmte Signal von der Kommunikationsvorrichtung (42) zu empfangen.

2. Intelligentes Schranksystem nach Anspruch 1, **dadurch gekennzeichnet, dass** die bewegbaren Elemente Schubladen sind, wobei das intelligente Schranksystem (20) ferner mehrere Laufschienenvorrichtungen aufweist, die konfiguriert sind, um die mehreren bewegbaren Elemente entsprechend zugeordnet zu tragen; wobei jede der Laufschienenvorrichtungen eine erste Schiene (27), eine zweite Schiene (28) und ein elastisches Element (86) aufweist, wobei die erste Schiene (27) konfiguriert ist, um an dem Schrankkörper (22) montiert zu sein/werden, wobei die zweite Schiene (28) relativ zu der ersten Schiene (27) bewegbar ist und konfiguriert ist, um das bewegbare Element zu tragen; wobei, wenn sich das bewegbare Element an der zurückgezogenen Position relativ zu dem Schrankkörper (22) befindet, das elastische Element (86) konfiguriert ist, um eine vorbestimmte elastische Kraft zu akkumulieren; wobei, wenn das Antriebselement (84) bewegt wird, um von dem ersten vorbestimmten Zustand in den zweiten vorbestimmten Zustand zu schalten, das elastische Element (86) konfiguriert ist, um die vorbestimmte elastische Kraft freizugeben, sodass die zweite Schiene (28) konfiguriert ist, um das bewegbare Element anzutreiben, um sich von der zurückgezogenen Position in die geöffnete Position als Reaktion auf die vorbestimmte elastische Kraft zu bewegen, die durch das elastische Element (86) freigegeben wird.

3. Intelligentes Schranksystem nach Anspruch 1 oder 2, ferner **gekennzeichnet durch** eine kabellose Vorrichtung (44), wobei die Kommunikationsvorrichtung (42) mit der Steuervorrichtung (32) durch die kabellose Vorrichtung (44) verbunden ist.

4. Intelligentes Schranksystem nach Anspruch 3, **dadurch gekennzeichnet, dass** die Kommunikationsvorrichtung (42) mit einem Anwendungsprogramm installiert ist und die Kommunikationsvorrichtung (42) konfiguriert ist, um das vorbestimmte Signal durch das Anwendungsprogramm zu übertragen.

5. Intelligentes Schranksystem nach Anspruch 4, **dadurch gekennzeichnet, dass** das Anwendungsprogramm eine Sprachfunktion hat, die konfiguriert ist, um ein Objekt (90), das in einem der bewegbaren Elemente gespeichert ist, gemäß einer Stimme eines Benutzers zu finden.

6. Intelligentes Schranksystem nach Anspruch 4 oder 5, **dadurch gekennzeichnet, dass** das Anwendungsprogramm eine Barcodefunktion hat, die konfiguriert ist, um ein Objekt (90), das in einem der bewegbaren Elemente gespeichert ist, gemäß einem Barcode zu finden, der von einem Benutzer abgetastet wird.

7. Intelligentes Schranksystem nach irgendeinem der Ansprüche 1 bis 6, **dadurch gekennzeichnet, dass** die Steuereinheit elektrisch mit der Steuervorrichtung (32) in einer kabelgebundenen Weise verbunden ist.

8. Intelligentes Schranksystem nach irgendeinem der Ansprüche 1 bis 7, **dadurch gekennzeichnet, dass** die Steuereinheit elektrisch mit dem elektronischen Modul in einer kabelgebundenen Weise verbunden ist und konfiguriert ist, um die Antriebsvorrichtung (88) zu steuern, um das Antriebselement (84) anzutreiben.

9. Intelligentes Schranksystem nach Anspruch 3, **dadurch gekennzeichnet, dass** die Steuervorrichtung (32) eine erste Speichereinheit (50) aufweist, die konfiguriert ist, um einen Satz von vorbestimmten Daten des intelligenten Schranksystems (20) zu speichern.

10. Intelligentes Schranksystem nach Anspruch 9, **dadurch gekennzeichnet, dass** die Kommunikationsvorrichtung (42) konfiguriert ist, um eine Kommunikationsverbindung mit der Steuervorrichtung (32) herzustellen, sodass der Satz von vorbestimmten Daten, der in der ersten Speichereinheit (50) der Steuervorrichtung (32) gespeichert ist, synchron aktualisiert und in einer zweiten Speichereinheit (52) der Kommunikationsvorrichtung (42) gespeichert wird.

11. Intelligentes Schranksystem nach Anspruch 10, **dadurch gekennzeichnet, dass** die kabellose Vorrichtung (44) konfiguriert ist, um eine Kommunikationsverbindung mit der Steuervorrichtung (32) durch Betreiben der Kommunikationsvorrichtung (42) herzustellen, sodass der Satz von vorbestimmten Daten, der in der ersten Speichereinheit (50) der Steuervorrichtung (32) gespeichert ist, synchron aktualisiert und in einer dritten Speichereinheit (54) der kabellosen Vorrichtung (44) gespeichert ist/wird.

12. Intelligentes Schranksystem nach Anspruch 11, ferner **gekennzeichnet durch** einen Cloud-Server (48), wobei die kabellose Vorrichtung (44) konfiguriert ist, um eine Kommunikationsverbindung mit dem Cloud-Server (48) durch Betreiben der Kommunikationsvorrichtung (42) herzustellen, sodass der Satz von vorbestimmten Daten, der in der dritten Speichereinheit (54) der kabellosen Vorrichtung (44) gespeichert ist/wird, synchron aktualisiert und in einer vierten Speichereinheit (56) des Cloud-Servers (48) gespeichert wird.

13. Intelligentes Schranksystem nach Anspruch 12, ferner **gekennzeichnet durch** ein Gateway (46), wobei die kabellose Vorrichtung (44) konfiguriert ist, um die Kommunikationsverbindung mit dem Cloud-Server (48) durch das Gateway (46) herzustellen; wobei die Kommunikationsvorrichtung (42) konfiguriert ist, um eine Kommunikationsverbindung mit dem Cloud-Server (48) herzustellen.

14. Intelligentes Schranksystem nach irgendeinem der Ansprüche 1 bis 13, **dadurch gekennzeichnet, dass** der Sensor (62) elektrisch mit der Steuervorrichtung (32) verbunden ist.

15. Intelligentes Schranksystem nach irgendeinem der Ansprüche 1 bis 14, **dadurch gekennzeichnet, dass** der Sensor (62) ein Radarsensor ist.

## Revendications

1. Système d'armoire intelligente (20), comprenant :
un corps d'armoire (22) ;
une pluralité d'éléments mobiles disposés sur le corps d'armoire (22) et pouvant se déplacer entre une position rétractée et une position ouverte par rapport au corps d'armoire (22) ;
un dispositif de commande (32) disposé sur le corps d'armoire (22) ;
**caractérisé par** :
une unité de commande reliée électriquement au dispositif de commande (32) ;
un module électronique relié électriquement à l'unité de commande, le module électronique comprenant un dispositif d'entraînement (88) configuré pour entraîner un élément d'entraînement (84) afin qu'il se déplace ;
un module d'alimentation en puissance (60) configuré pour alimenter en puissance au moins l'un parmi le dispositif de commande (32), l'unité de commande et le module électronique ;
un capteur (62) disposé sur le corps d'armoire (22) et configuré pour détecter si un utilisateur s'approche du corps d'armoire (22) ; et
un dispositif de communication (42) configuré pour transmettre un signal prédéterminé ;
dans lequel, lorsque le dispositif de commande (32) reçoit le signal prédéterminé, le dispositif de commande (32) est configuré pour notifier à l'unité de commande de commander le dispositif d'entraînement (88) afin de déplacer l'élément d'entraînement (84) pour passer d'un premier état prédéterminé à un deuxième état prédéterminé, afin de permettre à l'un des éléments mobiles d'être éloigné de la position rétractée ;
dans lequel, lorsque le capteur (62) détecte qu'un utilisateur s'approche du corps d'armoire (22), le système d'armoire intelligente (20) est configuré pour passer d'un mode d'économie d'énergie à un mode de fonctionnement, de telle sorte que le dispositif de commande (32) soit configuré pour être activé pour recevoir le signal prédéterminé provenant du dispositif de communication (42).

2. Système d'armoire intelligente selon la revendication 1, **caractérisé en ce que** les éléments mobiles sont des tiroirs, le système d'armoire intelligente (20) comprend en outre une pluralité d'ensembles de glissières configurés pour supporter la pluralité d'éléments mobiles de manière correspondante ; dans lequel chacun des ensembles de glissières comprend un premier rail (27), un deuxième rail (28) et un élément élastique (86), le premier rail (27) est configuré pour être monté sur le corps d'armoire (22), le deuxième rail (28) est mobile par rapport au premier rail (27) et configuré pour supporter l'élément mobile ; dans lequel, lorsque l'élément mobile se trouve en position rétractée par rapport au corps d'armoire (22), l'élément élastique (86) est configuré pour accumuler une force élastique prédéterminée ; dans lequel, lorsque l'élément d'entraînement (84) est déplacé pour passer du premier état prédéterminé au deuxième état prédéterminé, l'élément élastique (86) est configuré pour libérer la force élastique prédéterminée, de telle sorte que le deuxième rail (28) soit agencé pour entraîner l'élément mobile à se déplacer de la position rétractée à la position ouverte en réponse à la force élastique prédéterminée libérée par l'élément élastique (86).

3. Système d'armoire intelligente selon la revendication 1 ou 2, **caractérisé en outre par** un dispositif sans fil (44), dans lequel le dispositif de communication (42) est relié au dispositif de commande (32) par l'intermédiaire du dispositif sans fil (44).

4. Système d'armoire intelligente selon la revendication 3, **caractérisé en ce que** le dispositif de communication (42) est équipé d'un programme d'application, et le dispositif de communication (42) est configuré pour transmettre le signal prédéterminé par l'intermédiaire du programme d'application.

5. Système d'armoire intelligente selon la revendication 4, **caractérisé en ce que** le programme d'application comporte une fonction vocale configurée pour localiser un objet (90) rangé dans l'un des éléments mobiles en fonction de la voix d'un utilisateur.

6. Système d'armoire intelligente selon la revendication 4 ou 5, **caractérisé en ce que** le programme d'application comporte une fonction de code-barres configurée pour localiser un objet (90) rangé dans l'un des éléments mobiles en fonction d'un code-barres scanné par un utilisateur.

7. Système d'armoire intelligente selon l'une quelconque des revendications 1 à 6, **caractérisé en ce que** l'unité de commande est reliée électriquement au dispositif de commande (32) de manière filaire.

8. Système d'armoire intelligente selon l'une quelconque des revendications 1 à 7, **caractérisé en ce que** l'unité de commande est reliée électriquement au module électronique de manière filaire, et est configurée pour commander le dispositif d'entraînement (88) afin d'entraîner l'élément d'entraînement (84).

9. Système d'armoire intelligente selon la revendication 3, **caractérisé en ce que** le dispositif de commande (32) comprend une première unité de stockage (50) configurée pour stocker un ensemble de données prédéterminées du système d'armoire intelligente (20).

10. Système d'armoire intelligente selon la revendication 9, **caractérisé en ce que** le dispositif de communication (42) est configuré pour établir une liaison de communication avec le dispositif de commande (32), de telle sorte que l'ensemble de données prédéterminées stockées dans la première unité de stockage (50) du dispositif de commande (32) soit mis à jour de manière synchrone et stocké dans une deuxième unité de stockage (52) du dispositif de communication (42).

11. Système d'armoire intelligente selon la revendication 10, **caractérisé en ce que** le dispositif sans fil (44) est configuré pour établir une liaison de communication avec le dispositif de commande (32) moyennant l'actionnement du dispositif de communication (42), de telle sorte que l'ensemble de données prédéterminées stockées dans la première unité de stockage (50) du dispositif de commande (32) soit mis à jour de manière synchrone et stocké dans une troisième unité de stockage (54) du dispositif sans fil (44).

12. Système d'armoire intelligente selon la revendication 11, **caractérisé en outre par** un serveur cloud (48), dans lequel le dispositif sans fil (44) est configuré pour établir une liaison de communication avec le serveur cloud (48) par l'actionnement du dispositif de communication (42), de telle sorte que l'ensemble de données prédéterminées stockées dans la troisième unité de stockage (54) du dispositif sans fil (44) soit mis à jour de manière synchrone et stocké dans une quatrième unité de stockage (56) du serveur cloud (48).

13. Système d'armoire intelligente selon la revendication 12, **caractérisé en outre par** une passerelle (46), dans lequel le dispositif sans fil (44) est configuré pour établir la liaison de communication avec le serveur cloud (48) par l'intermédiaire de la passerelle (46) ; dans lequel le dispositif de communication (42) est configuré pour établir une liaison de communication avec le serveur cloud (48).

14. Système d'armoire intelligente selon l'une quelconque des revendications 1 à 13, **caractérisé en ce que** le capteur (62) est connecté électriquement au dispositif de commande (32) .

15. Système d'armoire intelligente selon l'une quelconque des revendications 1 à 14, **caractérisé en ce que** le capteur (62) est un capteur radar.
